# EUROPEAN PATENT APPLICATION

(11) **EP 1 727 167 A2**
(43) Date of publication of application: **29.11.2006**
(21) Application number: 06010845.3
(22) Date of filing: 26.05.2006
(51) Int. Cl.: H01G 9/20

(54) **Photochargeable layered capacitor comprising photovoltaic electrode unit and layered capacitor unit**

(30) Priority: 27.05.2005 JP 2005156436
(71) Applicant: Peccell Technologies Inc, Yokohama-shi Kanagawa 225-8502 (JP)
(72) Inventor: Miyasaka, Tsutomu, Machida-shi Tokyo, 194-0041 (JP); Murakami, Takurou, Kanagawa, 229-1101 (JP)
(74) Representative: Albrecht, Thomas

(57) **Abstract**

The present invention provides a photochargeable layered capacitor comprising a layered capacitor unit and a photovoltaic electrode unit. The layered capacitor unit comprises an outer counter-electrode layer, an outer storage material layer, a separator impregnated with an ionic electrolyte, an inner storage material layer and an inner counter-electrode layer in this order. The photovoltaic electrode unit comprises a transparent substrate, a transparent conductive layer, a semiconductor layer and a charge transfer layer in this order. The charge transfer layer of the photovoltaic electrode unit is in junction with an outer surface of the inner counter-electrode layer of the layered capacitor unit. The inner counter-electrode layer comprises a single metal sheet.

## Description

### FIELD OF THE INVENTION

The present invention relates to a photochargeable layered capacitor. The photochargeable layered capacitor can convert light energy (particularly sunlight) to electric energy and store the electric energy simultaneously. The capacitor can discharge the stored electric energy to supply it outside even in the darkness.

### BACKGROUND OF THE INVENTION

Exhaustion of fossil fuel resources is approaching. Use of the fossil fuel generates carbon dioxide, which destroys global environment. Natural energies such as sunlight are noted to solve social problems caused by the fossil fuel. It is important to use the natural energies effectively to supply electric power.

A solar battery is one of means to convert the sunlight into the electric power. A conventional solar battery is a solid junction type, which uses silicone crystals, an amorphous silicone thin film or a multilayered non-silicone thin film. The solar battery of the solid junction type has intensively been researched to improve energy conversion efficiency.

The solar battery of the solid junction type has some drawbacks, such as an expensive manufacturing cost and a long energy payback time. An organic solar battery, particularly a solar battery of a dye-sensitizing type has advantages of an inexpensive manufacturing cost and a short energy payback time. US Pat. No. 4,927,721 and Nature, 1991, vol. 353, p. 737-740 discloses a photo-electrochemical cell comprising a polycrystalline metal oxide semiconductor and a monomolecular chromophore layer.

The solar battery does not have a function of storing the electric power converted from daylight. Accordingly, the battery cannot supply the electric power at night. The electric power can be stored as electrochemical energy of a redox reaction in a secondary battery or an electrochemical capacitor (faradaic storage method). The electric power can also be stored as an electrostatic charge that is a capacity change of an electric double layer in an electronic double layer (non-faradaic storage method). These methods use characteristics of ions.

The electronic double layer (EDL, hereinafter) capacitor is a storage element for electronic charge, which basically does not need a redox reaction. The EDL has an advantage of long life because an electrode material is not degraded in the redox reaction. The EDL usually comprises a pair of storage layers. The storage layer comprises an electrode layer and a storage material layer. The storage material layer mainly comprises a carbonaceous material such as active carbon having a large specific surface area. An insulating separator is sandwiched between the pair of the storage layers. The separator is impregnated with an electrolytic solution. A voltage is applied between the two electrode layers to store electronic charge in the electronic layers (storage material layers), each of which is arranged along an interface between the electrode layer and the electrolyte layer (separator). The EDL can input and output a large electronic power for a short time. In this regard, the EDL is superior to the secondary battery of the redox reaction type. Further, the EDL has a long life in charge-discharge cycles, which is 100 times or more that of the secondary battery. Therefore, the EDL has been used in various industrial fields, for example as a backup electric source for a memory and an actuator of IC or LSI.

An electrochemical capacitor is also noted to further increase the capacity. In the electrochemical capacitor, a redox active material is used in place of the active carbon in the EDL. The electrochemical capacitor also has a ling life compared with the secondary battery.

A solar energy storage system should store an electronic power generated in a solar battery, and supply the electronic power even in the absence of the daylight. The solar energy storage system can be constructed by electronically and mechanically combining the solar battery with the storage battery. However, the method of combining batteries requires an additional manufacturing cost. Further, the method causes electronic losses while converting the sunlight into the electric energy, storing it and regenerating it. Therefore, the system of the method as a whole causes large electronic loss.

Japanese Patent Provisional Publication No. 2004-221531 discloses a photochargeable layered capacitor comprising a transparent substrate, a semiconductor layer, an ionic electrolyte layer, a carbonaceous layer and a condenser layer (electrode layer) in this order.

Japanese Patent Provisional Publication No. 2004-288985 discloses a chargeable solar battery comprising a first electrolytic solution and a second electrolytic solution, which are separated by a cation exchange membrane. The first electrolytic solution contains a photosensitive anode and a counter-electrode comprising a metal mesh. The second electrolytic solution contains an electrolytic charge storage electrode.

### SUMMARY OF THE INVENTION

The photochargeable layered capacitor disclosed in Japanese Patent Provisional Publication No. 2004-221531 comprises a photovoltaic electrode unit and a storage unit. The capacitor can storage electric energy converted from daylight, and can discharge and supply the energy outside even in the darkness. The capacitor shows a high charging efficiency, but an insufficient discharging efficiency. Particularly, the discharged electric energy has a low voltage.

The present inventors have studied the photochargeable layered capacitor disclosed in Japanese Patent Provisional Publication No. 2004-221531. They found a cause of the problem in the capacitor while discharging the electric energy. The inventors finally note that another electrode layer can be provided between the photovoltaic electrode unit and the storage unit to solve the problem.

The present invention provides a photochargeable layered capacitor comprising a layered capacitor unit and a photovoltaic electrode unit, said layered capacitor unit comprising an outer counter-electrode layer, an outer storage material layer, a separator impregnated with an ionic electrolyte, an inner storage material layer and an inner counter-electrode layer in order, and said photovoltaic electrode unit comprising a transparent substrate, a transparent conductive layer, a semiconductor layer and a charge transfer layer in order, wherein the charge transfer layer of the photovoltaic electrode unit is in junction with an outer surface of the inner counter-electrode layer of the layered capacitor unit, and wherein the inner counter-electrode layer comprises a single metal sheet.

The photochargeable layered capacitor of the present invention has a simple structure having a photovoltaic electrode unit and a storage unit. The capacitor of the invention can store an electric energy converted from daylight with high efficiency, and can discharge and supply the electric energy outside with high efficiency even in the darkness.

### BRIEF DESCRIPTION OF THE DRAWING

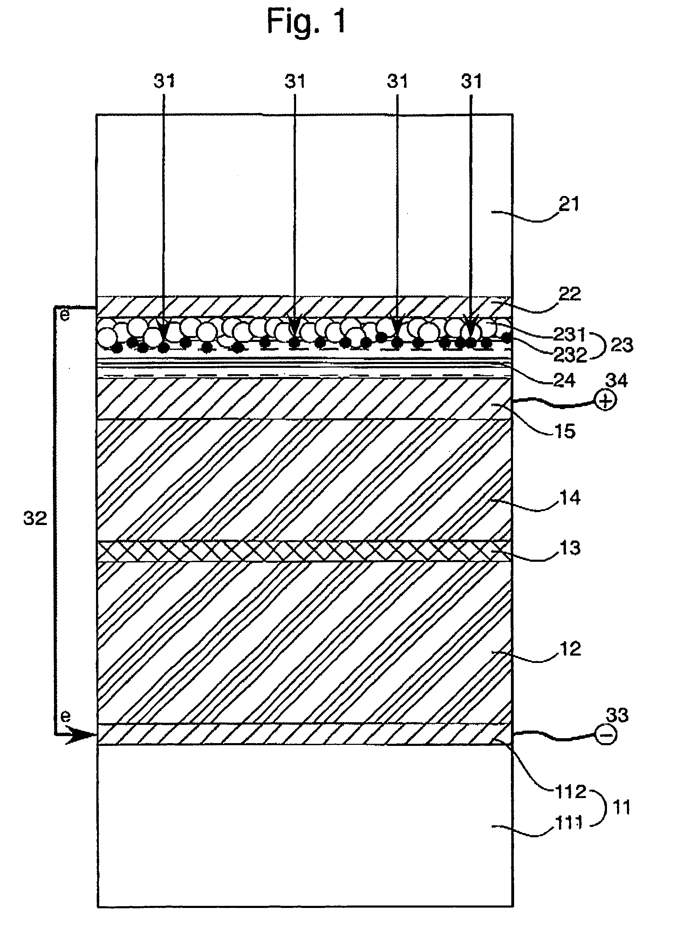

Fig. 1 is a sectional view schematically illustrating the preferred embodiment of the photochargeable layered capacitor of the present invention.

### DETAILED DESCRIPTION OF THE INVENTION

The photochargeable layered capacitor of the present invention is described below referring to the drawing.

Fig. 1 is a sectional view schematically illustrating the preferred embodiment of the photochargeable layered capacitor.

The photochargeable layered capacitor shown in Fig. 1 comprises a layered capacitor unit (11-15) and a photovoltaic electrode unit (21-24).

The layered capacitor unit comprises an outer counter-electrode layer (11), an outer storage material layer (12), a separator impregnated with an ionic electrolyte (13), an inner storage material layer (14) and an inner counter-electrode layer (15) in this order. The outer counter-electrode layer (11) shown in Fig. 1 comprises a plastic substrate (111) and a conductive layer (112). The inner counter-electrode layer (15) shown in Fig. 1 consists of a single metal sheet. The neighboring layers shown in Fig. 1 are electrically connected to each other.

The photovoltaic electrode unit comprises a transparent substrate (21), a transparent conductive layer (22), a semiconductor layer (23) and a charge transfer layer (24) in this order. The charge transfer layer (24) is in junction with the photovoltaic electrode and the surface of the inner counter-electrode layer (15) of the photovoltaic electrode unit is provided on a surface of the inner counter-electrode layer (15) of the layered capacitor unit. The semiconductor layer (23) shown in Fig. 1 comprises a porous layer comprising semiconductor particles (231) having a surface adsorbing a dye (232).

The photochargeable layered capacitor shown in Fig. 1 has an outer electrode (32) which electrically connects via external circuits the transparent conductive layer (22) of the photovoltaic electrode unit and the outer counter-electrode layer (11) of the layered capacitor unit. The external circuit (32) functions when charging of electric energy is conducted. Accordingly, the external circuit (32) can temporarily be attached to the photochargeable layered capacitor, or can temporarily connect the layers only while charging the electric energy. The photochargeable layered capacitor shown in Fig. 1 further has output terminals (33, 34). The output terminals (33, 34) are attached to the outer counter-electrode layer (11) and the inner counter-electrode layer (12) of the layered capacitor unit. The output terminals (33, 34) can not be attached to the capacitor, and the terminals can temporality be connected to the electrode layers only when discharging of the electric energy is conducted.

The photochargeable layered capacitor shown in Fig. 1 can be prepared by placing the photovoltaic electrode unit (21-24) on the layered capacitor unit (11-15). The photochargeable layered capacitor can also be prepared according to another process in laminating the layers. There is no specific limitation in order of laminating the layers.

There is also no specific limitation with respect to the structure of the photochargeable layered capacitor of the present invention. Examples of the structures include a film-shape, a coin-shape, a cylindrical shape and a square-shape.

The photochargeable layered capacitor of the present invention can be irradiated with light. The photochargeable layered capacitor shown in Fig. 1 is irradiated with light (31) thorough the transparent substrate (21) and the transparent conductive layer (22). The photochargeable layered capacitor can also be irradiated with light from the sides of the photochargeable layered capacitor or thorough the layered capacitor unit (11-15).

In the photochargeable layered capacitor of the present invention, the photovoltaic electrode unit (21-24) adsorbs light, and is then electrochemically excited to a more negative potential. In the light-excited state, electric charge is separated to give an electron and a positive-hole. The formed positive-hole is transferred through the charge transfer layer (24) to the inner counter-electrode layer (15), and stored in the inner storage material layer (14). The charge transfer layer (24) can comprise an ionic electrolytic solution containing a redox agent, or a hole transfer material. The inner storage material layer (14) can comprise a carbonaceous material or an electrodically active material. The carbonaceous material can store electronic charge in an electric double layer. The electrodically active material can store electronic charge by a redox reaction.

The electron formed in the photovoltaic electrode unit (21-24) is transferred through the external circuit (32) to the outer counter-electrode layer (11), and stored in the outer storage material layer (12). The outer storage material layer can also comprise the carbonaceous material or the electrodically active material, which are described above about the inner storage material layer (14).

After the photovoltaic electrode unit is irradiated with light, a positive electronic quantity (coulomb) is charged in the inner storage material layer (14), and a negative electronic quantity is charged in the outer storage material layer (12).

The photochargeable layered capacitor of the present invention can be charged and discharged, as is described below.

The capacitor can be charged by irradiating the photovoltaic electrode unit with light. In the photo-charge process, the positive charge is stored in the inner storage material layer (14), and a negative charge is stored in the outer storage material layer (12). When the photo-charge process is completed, the voltage in the external circuit between the photovoltaic electrode and the outer counter-electrode is saturated. Therefore, the end of the photo-charge process can be indicated by the charging current approaching almost zero. The layered capacitor unit placed in the darkness can be discharged by connecting an electronic machine (load) to the output terminals (33, 34). The electronic machine consumes the discharged electric energy. The discharging characteristics can be evaluated by measuring the change of voltage under the condition of a constant charging current (under Galvanostatic conditions). The constant charging current can be obtained by means of a Galvanostatic control circuit.

The photochargeable layered capacitor is often used in the condition where light exposure is greatly and frequently changed, for example where the capacitor is used outdoors. An abrupt change in current while charging the capacitor can cause reverse current. Various devices such as a rectifier, a diode or a switch can be attached to the circuit to prevent the reverse current.

### [Layered capacitor unit]

### (Outer counter-electrode layer)

The outer counter-electrode layer (substrate) preferably is a flexible material to prepare a flexible capacitor, which can be mechanically bent or rolled.

The outer counter-electrode layer (substrate) can comprise a single metal sheet or a combination of a plastic substrate with a conductive layer.

The metal sheet can be made of various metals such as iron (stainless), silver, aluminum, copper, nickel, titanium, platinum or an alloy thereof. The metal sheet preferably is made of titanium or an alloy thereof. The metal sheet can have a surface covered with another metal. For example, a metal sheet made of titanium or an alloy thereof can have a surface covered with platinum membrane. The metal sheet has a thickness preferably in the range of 5 to 500 µm, more preferably in the range of 10 to 200 µm, and most preferably in the range of 20 to 100 µm. The metal membrane formed on the metal sheet has a thickness preferably in the range of 2 to 200 nm, more preferably in the range of 5 to 100 nm, and most preferably in the range of 10 to 50 nm.

The plastic substrate preferably has a heat-resistance, a chemical resistance and a gas shielding function. The plastic materials for the substrate include a polyester, such as polyethylene terephthalate (PET), polyethylene naphthalate (PEN), polycarbonate (PC) and polyarylate (PAr); a polyolefin, such as syndiotactic polystyrene (SPS); polysulfide, such as polyphenylene sulfide (PPS); polysulfone (PES); polyester sulfone (PES); polyether imide (PEI); and polyimide (PI). The plastic material preferably is polyester, and more preferably is polyethylene terephthalate (PET) or polyethylene naphthalate (PEN). The plastic substrate has a thickness preferably in the range of 20 µm to 2 mm, more preferably in the range of 50 µm to 1 mm, and most preferably in the range of 100 to 500 µm.

The conductive layer can be made of a conductive metal oxide, such as tin oxide, fluorine-doped tin oxide (FTO), indium tin oxide (ITO), zinc oxide and indium zinc oxide (IZO); a metal, such as iron (stainless), silver, aluminum, copper, nickel, titanium, platinum and an alloy thereof; or a conductive polymer such as polyacetylene, polypyrrole, polythiophene, polyphenylene and polyphenylene vinylene. The metal conductive layer can be a metal foil, an etched metal foil and an expanded metal layer. A plastic film or a glass plate having a lattice pattern made of a metal (e.g., copper, silver, aluminum, zinc, nickel) or a carbonaceous material can also be used as the conductive layer. The conductive layer has a thickness preferably in the range of 50 nm to 5 µm, more preferably in the range of 100 nm to 2 µm, and most preferably in the range of 200 nm to 1 µm. The conductive layer has a surface resistance preferably of not larger than 15 Ω per square, more preferably of not larger than 5 Ω per square, and most preferably of not larger than 1 Ω per square.

### (Outer and inner storage material layer)

The outer and inner storage material preferably is a carbonaceous material or an electrodically active material having a redox function. Each of the outer and inner storage materials can be a carbonaceous material. Each of the outer and inner storage materials can be an electrodically active material having a redox function. The outer and inner storage materials can be different from each other.

The carbonaceous material can store the charge as an electrostatic double layer capacity. The electrodically active material having a redox function can store the electric energy as a result of a redox reaction. The carbonaceous material stores the charge according to a faradaic storage method. The electrodically active material stores the charge according to a non-faradaic storage method.

The carbonaceous material preferably is used to store the charge as a double layer capacity. The carbonaceous material is generally used in the conventional electrolytic double layer capacitor. The carbonaceous material has preferably high polarization, a large specific surface area, a large bulk density and a small resistance. The carbonaceous material also preferably is electrochemically inert. The most preferred carbonaceous material is active carbon. Examples of the active carbons include active carbon fiber prepared by actively carbonizing phenol resin fiber, active carbon power prepared by carbonizing and activating a plant material such as wood tips, and granular active carbon. The other materials for a polarized electrode are described in Technologies & Materials for EDLC (written in Japanese), CMC Publishing Co., Ltd. (1998); Electric Double Layer Capacitor and Storage System (written in Japanese), Nikkan Kogyo Shimbun, Ltd. (1999); and B.E. Conway, Electrochemical Super Capacitor, Kluwer Academic/Plenum Publishers, NY (1999).

Japanese Patent Provisional Publication No. 10-199767 discloses a carbonaceous material for an electric double layer capacitor having a large electrostatic capacity. The carbonaceous material is prepared by carbonizing carbon source such as petroleum cokes or coal pitch cokes in an inert gas atmosphere, and activating them with an alkali such as potassium hydroxide. Japanese Patent Provisional Publication No. 11-317333 discloses various materials for an electrode of an electric double layer capacitor having a large electrostatic capacity. The carbonaceous material can also be porous carbon having a large specific surface area, which can be prepared from polytetrafluoroethylene (PTFE). A conductive material such as graphite, carbon black or acetylene black can be added to the active carbon or other carbonaceous materials. The carbonaceous material can be mesoporous (having micropores, pore size: 2 nm to 50 nm), microporous (having micropores, pore size: 2 nm or less) or macroporous (having micropores, pore size: 50 nm or more). The mesoporous carbonaceous material is particularly preferred. B.E. Conway, Electrochemical Capacitor, Ground, Material and Application, NTS (2001) further discloses carbonaceous materials, which are available in the present invention.

The carbonaceous material has a specific surface area preferably in the range of 500 to 5,000 m²/g, and more preferably in the range of 1,000 to 5,000 m²/g. The specific surface area can be measured according to BET method. The carbonaceous material preferably is in the form of particles. The carbonaceous particles have an average particle size preferably in the range of 0.02 to 5 µm, and more preferably in the range of 0.02 to 0.5 µm.

The outer and inner storage material layer made of a carbonaceous material has a thickness preferably in the range of 20 µm to 2 mm, more preferably in the range of 50 µm to 1 mm, and most preferably in the range of 100 to 500 µm.

An inorganic or organic electrodically active material can store the charge as a result of a redox (faradaic) reaction. Examples of the inorganic electrodically active materials are carbonaceous materials such as graphite, mesophase pitch, carbon fiber and carbon nanotube. The carbonaceous materials can be activated by adding an anion or cation to them and subjecting them to a redox reaction. Examples of the inorganic active materials further include oxides or sulfides of metals, particularly polyvalent or transition metals. Examples of the polyvalent or transition metals include ruthenium, iridium, nickel, tin, cobalt, vanadium, zirconium, titanium, manganese and tungsten. Examples of the organic active materials include conductive polymers such as polyaniline, polypyrrole, polyacene, polythiophene, polyindole and derivatives thereof; polyquinoxaline and derivatives thereof; and organic charge transfer complexes and oligomers thereof. The active material can be mixed with a carbonaceous material for the electric double storage layer.

The outer and inner storage material layer made of an electrodically active material has a thickness preferably in the range of 2 to 200 µm, more preferably in the range of 5 to 100 µm, and most preferably in the range of 10 to 50 µm.

The outer and inner storage material layer made of a carbonaceous material and an electrodically active material has a thickness preferably in the range of 10 µm to 2 mm, more preferably in the range of 20 µm to 1 mm, and most preferably in the range of 50 to 500 µm.

The outer and inner storage material can contain a binder to solidify the layer. Examples of the binders include polyolefin halides, such as polyvinylidene fluoride, polytetrafluoroethylene, polypropylene hexafluoride, polyethylene chloride trifluoride, and copolymers thereof (e.g., vinylene fluoride-propylene hexafluoride copolymer); synthetic rubbers, such as isoprene rubber, butadiene rubber, nitrile rubber, chloroprene rubber, and copolymers thereof (e.g., ethylenepropylene rubber, acrylonitrile-butadiene-styrene copolymer); polyester, such as polycarbonate; and polyamide.

A buffer layer can be provided between the outer electrode layer and the outer storage layer or between the inner electrode layer and the inner storage layer. The buffer layer has a function of rectifying transfer (current) of electron. The buffer layer can be a thin film of an insulator, a semiconductor or a conductor. Examples of the insulators include oxides, such as aluminum oxide, silicon oxide and magnesium oxide. Various organic or inorganic semiconductor materials can be used in the buffer layer. Further, an electron conductive or a positive-hole conductor can be used in the buffer layer. Examples of the conductive materials include oxides, such as tin oxide, zinc oxide, nickel oxide; a polymer such as a polythiophene and derivatives thereof; a carbonaceous material, such as fullerene and derivatives thereof; and organic light conductors, such as phthalocyanine and derivatives thereof, a merocyanine dye and perylene.

### (Separator impregnated with electrolyte)

The separator has a function of preventing short-circuit between the outer and inner electrodes. The separator is impregnated with an ionic electrolyte. The electrolyte preferably is used in the form of an electrolytic solution. The thickness of the separator preferably is the same as the thickness of the electrolytic solution layer. In other words, the separator preferably is united with the electrolytic solution layer.

The separator preferably is made of an insulator. The separator preferably is in the form or a film or particles.

The film is preferred to the particles. The film preferably is a porous resin film such as a filter or a fibrous polymer film. The porous resin film can be made of an polyolefin (e.g., polyethylene, polypropylene). Examples of the fibrous polymer films include non-woven fabric or a resin such as polyolefin (e.g., polypropylene). A porous membrane made of a pulp (which is usually referred to as an electrolytic condenser paper) can also be used as the separator. A surface of the separator can be subjected to a hydrophilic or hydrophobic treatment.

The film separator has a thickness preferably of 80 µm or less, more preferably in the range of 5 to 50 µm, and most preferably in the range of 5 to 25 µm. The film separator has a porosity preferably in the range of 40 to 85%.

The particle separator can be made of inorganic or organic materials. Examples of the inorganic materials include silicone; and oxides, such as silica and alumina. Examples of the organic materials include polyolefins, such as polystyrene, polyethylene; poly(meth)acrylate, such as polymethyl methacrylate (PMMA); and polyamides (nylon). The particle separator preferably has a uniform particle size distribution. The average particle size of the particle separator (i.e., thickness of the separator) preferably is in the range of 10 to 200 µm, and more preferably in the range of 10 to 50 µm.

The electrolyte preferably is used in the form of a solution or a liquid. An organic (non-aqueous) electrolytic solution, an aqueous electrolytic solution or an molten electrolytic salt can be used as the electrolyte. A polymer electrolytic solution can also be used.

The organic solvents of the organic (non-aqueous) electrolytic solution include carbonates, such as dimethyl carbonate, diethyl carbonate, ethylene carbonate and propylene carbonate; nitriles, such as acetonitrile, propionitrile; lactones, such as γ-butyrolactone, α-methyl-γ-butyrolactone, β-methyl-γ-butyrolactone, γ-valerolactone and 3-methyl-g-valerolactone; sulfoxides, such as dimethyl sulfoxide and diethyl sulfoxide; amides, such as dimethylformamide and dimethylformamide; ethers, such as tetrahydrofuran and dimethoxyethane; and sulfolanes, such as dimethylsulfolane and sulfolane. Two or more organic solvents can be used in combination.

The electrolyte contained in the organic (non-aqueous) electrolytic solution preferably is a supporting salt. The anion of the salt preferably is a tetraalkylammonium (e.g., tetraethylammonium, tetrabutylammonium) or a tetraalkylphosphonium. The cation of the salt preferably is a tetrafluoroborate or a hexafluorophosphate. Perchloric acid or an alkali halide can also be used as the electrolyte. The concentration of the electrolyte in the electrolytic solution preferably is in the range of 0.5 to 5 mole per liter, and more preferably in the range of 1 to 2.5 mole per liter.

The aqueous electrolytic solution can contain an acid, such as sulfuric acid or hydrochloric acid; a base, such as potassium hydroxide; or a salt thereof. The aqueous electrolytic solution preferably is an aqueous solution of a lanthanoid salt with an acid. The lanthanoid salt shows excellent charge and discharge characteristics under a condition of high current density.

The electrolyte preferably does not contain redox active compound. The electrolytic solution preferably comprises only an electrochemically stable supporting salt with a solvent.

### (Inner counter-electrode layer)

The inner counter-electrode layer (substrate) preferably is a flexible material to prepare a flexible capacitor, which can be mechanically bent or rolled.

The inner counter-electrode layer (substrate) comprises a single metal sheet.

The metal sheet can be made of various metals such as iron (stainless), silver, aluminum, copper, nickel, titanium, platinum or an alloy thereof. The metal sheet preferably is made of titanium or an alloy thereof. The metal sheet can have a surface covered with another metal. For example, a metal sheet made of titanium or an alloy thereof can have a surface covered with platinum membrane. The metal sheet has a thickness preferably in the range of 5 to 500 µm, more preferably in the range of 10 to 200 µm, and most preferably in the range of 20 to 100 µm. The metal membrane formed on the metal sheet has a thickness preferably in the range of 2 to 200 nm, more preferably in the range of 5 to 100 nm, and most preferably in the range of 10 to 50 nm.

### [Photovoltaic electrode unit]

### (Transparent substrate)

The transparent substrate can be made of a transparent plastic or glass. The transparent substrate preferably is a flexible material to prepare a flexible capacitor, which can be mechanically bent or rolled. Therefore, the transparent plastic is preferred to the glass.

The plastic substrate preferably has a heat-resistance, a chemical resistance and a gas shielding function. The plastic materials for the substrate include a polyester, such as polyethylene terephthalate (PET), polyethylene naphthalate (PEN), polycarbonate (PC) and polyarylate (PAr); a polyolefin, such as syndiotactic polystyrene (SPS); polysulfide, such as polyphenylene sulfide (PPS); polysulfone (PES); polyester sulfone (PES); polyether imide (PEI); and polyimide (PI). The plastic material preferably is a polyester, and more preferably is polyethylene terephthalate (PET) or polyethylene naphthalate (PEN). The plastic substrate has a thickness preferably in the range of 20 µm to 2 mm, more preferably in the range of 50 µm to 1 mm, and most preferably in the range of 100 to 500 µm.

### (Transparent conductive layer)

The transparent conductive layer can be made of a conductive metal oxide, such as tin oxide, fluorine-doped tin oxide (FTO), indium tin oxide (ITO), zinc oxide and indium zinc oxide tin (IZO); a metal, such as iron (stainless), silver, aluminum, copper, nickel, titanium, platinum and an alloy thereof; or a conductive polymer such as polyacetylene, polypyrrole, polythiophene, polyphenylene and polyphenylene vinylene. The metal conductive layer can be a metal foil, an etched metal foil and an expanded metal layer. A plastic film or a glass plate having a lattice or mesh pattern made of a metal (e.g., copper, silver, aluminum, zinc, nickel) or a carbonaceous material can also be used as the transparent conductive layer. The conductive layer has a thickness preferably in the range of 50 nm to 5 µm, more preferably in the range of 100 nm to 2 µm, and most preferably in the range of 200 nm to 1 µm. The conductive layer has a surface resistance preferably of not larger than 15 Ω per square, more preferably of not larger than 5 Ω per square, and most preferably of not larger than 1 Ω per square.

### (Semiconductor layer)

The semiconductor preferably is in the form of particles, or the semiconductor layer preferably has a porous structure. The porous layer has a surface roughness coefficient in terms of R preferably of 500 or more, and more preferably of 1,500 or more. The surface roughness coefficient represented by R is a ratio of an actual surface area of a material to an apparent projected area of the material. The ratio of R is represented by the formula of R = SM, wherein S is a specific surface area of a material (m²/g), and M is an amount of the material provided on the substrate (g/m²).

The semiconductor layer comprises an organic or inorganic semiconductor. The semiconductor can be crystalline or amorphous. The inorganic crystalline semiconductor is most preferred. Examples of the inorganic semiconductors include semiconductors of simple substances such as silicon and germanium; metal oxides; metal chalcogenide (e.g., sulfide, selenide, telluride); and metal phosphide. A compound of a perovskite structure can also be used as the semiconductor. The metal oxide and the metal chalcogenide are most preferred.

Examples of the metal oxides include oxides of titanium, tin, zinc, iron, tungsten, zirconium, strontium, indium, cerium, yttrium, lanthanum, vanadium, niobium and tantalum. Examples of the metal sulfides include oxides of cadmium, zinc, lead, silver, antimony and bismuth. Examples of the metal selenides include selenides of cadmium and lead. Examples of the metal tellurides include cadmium telluride. Examples of the metal phosphides include phosphides of zinc, gallium, indium and cadmium. Gallium-arsenic, copper-indium selenide and copper-indium sulfide are also preferably used as the semiconductor.

The most preferred semiconductor is a metal oxide semiconductor of n-type, such as TiO₂, TiSrO₃, ZnO, Nb₂O₃, SnO₂, WO₃. Two or more metal oxide semiconductors can be used in combination.

In the case that the semiconductor layer comprises only the semiconductor, the semiconductor preferably is of n-type showing optical absorption within the visible wavelength region of not shorter than 400 nm. In more detail, the semiconductor of n-type preferably shows an absorption peak corresponding to a band gap of the semiconductor within the visible wavelength region of not shorter than 400 nm. The semiconductor also preferably is spectrally sensitized to have sensitivity within a wavelength region of not shorter than 400 nm. The semiconductor layer used in the capacitor of the present invention preferably absorbs at least part of light within the visible wavelength region. Examples of the semiconductors showing absorption within the visible wavelength region include chalcogenides, such as cadmium sulfide, cadmium selenide, zinc sulfide and zinc selenide.

The semiconductor layer preferably is a porous semiconductor layer having an optically and spectrally sensitized surface. The surface is coated and sensitized with a dye. The porous semiconductor preferably is in the form of a mesoporous semiconductor thin film, which is formed by combining primary particles having a nanometer average particle size. The primary semiconductor particles have an average particle size preferably in the range of 5 to 100 nm, and more preferably in the range of 10 to 80 nm. The secondary particles have an average particle size preferably in the range of 0.01 to 1 µm. The particles can comprise two or more kinds of particles which are different from each other in particle size distribution. The particles can be mixed with relatively large semiconductor particles (size: 200 to 600 nm) to scatter incident light and to improve light harvesting efficiency.

The porous semiconductor layer can be sensitized with a dye. An organic sensitizing dye or a metal complex sensitizing dye can be used to cover the porous semiconductor. Examples of the organic dyes include cyanine dyes, merocyanine dyes, oxonol dyes, rhodanine dyes, indolenine dyes, xanthene dyes, squalirium dyes, polymethine dyes, coumarin dyes, riboflavin dyes and perylene dyes. Examples of the metal complex dyes include ruthenium complexes, metal phthalocyanine and derivatives thereof, and metal porphyrin and derivatives thereof (e.g., chlorophyll). The other natural or synthetic sensitizing dyes are described in Functional Material (written in Japanese), 2003, June, p. 5-18. Further, an organic dye such as coumarin disclosed in J. Chem. Phys., 2003, vol. B107, p. 597 can also be used as the sensitizing dye.

The semiconductor layer can contain a visible light-absorbing organic semiconductor or conductive material in addition to or in place of the above-mentioned inorganic semiconductor or the semiconductor sensitized with the dye. Examples of the organic semiconductors include merocyanine dyes, cyanine dyes and J-conjugate thereof, coumarin dyes, polyene dyes, metal phthalocyanine and derivatives thereof, porphyrin and derivatives thereof, and perylene and derivatives thereof. Examples of the light-absorbing organic conductive materials include polymer materials, such as polyaniline, polypyrrole, polyacene, polythiophene, poly(p-phenylene), poly(p-phenylene vinylene) and derivatives thereof; and fullerene and derivatives thereof. The organic conductive materials can have not only a sensitizing function but also a positive-hole transporting function.

The semiconductor layer has a thickness preferably in the range of 5 to 30 µm, and more preferably in the range of 7 to 20 µm. The porous semiconductor has a porosity preferably of not less than 40%, and more preferably of not less than 60%.

### (Charge transfer layer)

The charge transfer layer preferably has a positive-hole (positive charge) transporting function. The charge transfer layer can be made of an organic or inorganic positive-hole transporting material. The material preferably is an ionic electrolyte (preferably in the form of a liquid) containing a redox compound (redox active material). The material also preferably is a positive-hole transporting material (preferably in the form of a solid). A positive-hole formed in the conductor layer (particularly the dye of the layer) is transferred to a surface of the inner counter-electrode. The ionic electrolyte containing the redox compound preferably is an electrolytic solution in a volatile organic solvent, a non-volatile electrolytic liquid (such as room temperature molten salt), a pseudo-solid electrolyte having a high viscosity using a polymer electrolyte or a polymer gel, or a pseudo-solid electrolyte containing inorganic or organic micrometer or nanometer particle dispersion as matrix.

Examples of the redox compounds include a combination of I₂ with an iodide, such as a metal iodide (e.g., LiI, NaI, KI) and a quarternary ammonium iodide (e.g., a tetraalkylammonium iodide, pyridinium iodide, imidazolium iodide); a combination of Br₂ with a bromide such as a metal bromide (e.g., LiBr, NaBr, KBr) and a quarternary ammonium bromide (e.g., a tetraalkylammonium bromide, pyridinium bromide); a metal complex, such as a ferrocyanate-ferricyanate salt and a ferrocene-ferricynium ion; and a sulfur compound such as polysodium sulfide. The combination of I₂ with LiI or a quarternary ammonium iodide, such as pyridinium iodide or imidazolium iodide is particularly preferred.

Examples of the organic solvent of the electrolyte liquid containing a redox compound include carbonates, such as ethylene carbonate and propylene carbonate; alcohols, such as ethylene glycol monoalkyl ether and polyethylene glycol monoalkyl ether; polyhydric alcohols, such as ethylene glycol, polyethylene glycol, polypropylene glycol and glycerol; ethers, such as dioxane, ethylene glycol dialkyl ether and polyethylene glycol dialkyl ether; lactones, such as γ-butyrolactone, α-methyl-γ-butyrolactone, β-methyl-γ-butyrolactone, γ-valerolactone and 3-methyl-γ-valerolactone; nitriles, such as acetonitrile, methoxyacetonitrile, propionitrile and benzonitrile; and sulfoxides, such as dimethyl sulfoxide. The organic solvent preferably is a non-protic polar compound. Two or more organic solvent can be used in combination.

The non-volatile ionic liquid (room temperature molten salt) preferably is an alkyl imidazolium salt. Examples of the alkyl imidazoliums include dimethyl imidazolium, methyl propyl imidazolium, methyl butyl imidazolium and methyl hexyl imidazolium. Examples of the counter ion of the alkyl imidazolium salts include tetrafluoroborate, tetrafluromethanesulfonylimide and iodide. A pyridinium salt, an imidazolium salt or a triazolium salt can also be used as the non-volatile ionic liquid. The molten salts are described in Functional Material (written in Japanese), CMC Publishing Co., Ltd. (2004, November); Yukihiro Ohno, Ionic Liquid, Front Line and Future of Development (written in Japanese), CMC Publishing Co., Ltd. (2003); and Japanese Patent Provisional Publication Nos. 2001-196105, 2001-199961 and 2002-190323.

The ionic electrolyte liquid can be set to gel, or solidified by adding a polymer (e.g., polyacrylonitrile, polyvinylidene fluoride) or a gelling agent. The liquid can also be set to gel, or solidified by causing a crosslinking reaction of a polymer in the liquid. Further, the liquid can be solidified by mixing the liquid with carbon nanotube or micro particles of inorganic oxide (e.g., silica, titanium oxide).

A positive-hole transporting material can be used in the charge transfer layer. The positive-hole transporting material can be an organic solid substance, an inorganic solid substance or a mixture thereof. Examples of the organic positive-hole transporting materials include aromatic amines, oligothiophene compounds and polymers, such as polyvinyl carbazole, polypyrrole, polyacetylene, poly(p-phenylene), poly(p-phenylene vinylene), polythienylene vinylene, polythiophene, polyaniline, polytoluidine, polysilane and derivatives thereof. The positive-hole transporting materials used in an organic electroluminescence (EL) element can also be used in the charge transfer layer.

The inorganic positive-hole transporting material preferably is an inorganic semiconductor of p-type. The inorganic semiconductor or p-type preferably is a semiconductor compound containing a monovalent copper (I). Examples of the copper (I) semiconductor compounds include CuI, CuSCN, CuInSe₂, Cu(In, Ga)Se₂, CuGaSe₂, Cu₂O, CuS, CuGaS₂, CuInS₂ and CuAlSe₂. CuI and CuSCN are preferred, and CuI is most preferred. The other examples of the inorganic semiconductors of p-type include GaP, NiO, CoO, FeO, Bi₂O₃, MoO₂ and Cr₂O₃.

The charge transfer layer can comprise a separator. The separator has a function of preventing short-circuit between the photovoltaic electrode unit and the inner counter-electrode. The separator is preferably impregnated with the electrolyte and the redox compound. The thickness of the separator preferably is the same as the thickness of the charge transfer layer. In other words, the separator preferably is united with the charge transfer layer.

The separator preferably is made of an insulator. The separator preferably is in the form or a film or particles.

The film is preferred to the particles. The film preferably is a porous resin film such as a filter or a fibrous polymer film. The porous resin film can be made of an polyolefin (e.g., polyethylene, polypropylene). Examples of the fibrous polymer films include non-woven fabric or a resin such as polyolefin (e.g., polypropylene). A porous membrane made of a pulp (which is usually referred to as an electrolytic condenser paper) can also be used as the separator. A surface of the separator can be subjected to a hydrophilic or hydrophobic treatment.

The film separator has a thickness preferably of 80 µm or less, more preferably in the range of 5 to 50 µm, and most preferably in the range of 5 to 25 µm. The film separator has a porosity preferably in the range of 40 to 85%.

The particle separator can be made of inorganic or organic materials. Examples of the inorganic materials include silicone; and oxides, such as silica and alumina. Examples of the organic materials include polyolefins, such as polystyrene, polyethylene; poly(meth)acrylate, such as polymethyl methacrylate (PMMA); and polyamides (nylon). The particle separator preferably has a uniform particle size distribution. The average particle size of the particle separator (i.e., thickness of the separator) preferably is in the range of 10 to 200 µm, and more preferably in the range of 10 to 50 µm.

### EXAMPLE 1

### (Preparation of outer counter-electrode layer)

One surface of a polyethylene naphthalate (PEN) film (thickness: 200 µm) was covered with aluminum membrane (thickness: 500 nm) to prepare an outer counter-electrode layer.

### (Formation of outer storage material layer)

9 weight parts of porous active carbon (active carbon fiber) having specific surface area of 1,100 m²/g (measured according to BET method) and average primary particle size of 0.03 µm, 1 weight part of acetylene black and 1 weight part of N-methylpyrrolidone solution of polyvinylidene fluoride (binder) were mixed to form a paste. The aluminum surface of the outer counter-electrode layer was coated with the paste, dried at 60°C, and mechanically pressed to cover the aluminum surface with a carbonaceous layer containing active carbon (thickness: about 200 µm, coated amount of carbon: 2.5 mg/cm²). The formed film was further heated at 150°C in the dry air for 10 minutes.

### (Preparation of inner counter-electrode layer)

Surfaces of a titanium sheet (thickness: 50 µm) were covered with platinum membrane (thickness: 20 nm) to prepare an inner counter-electrode layer.

### (Formation of inner storage material layer)

10 weight parts of porous active carbon (active carbon fiber) having specific surface area of 1,100 m²/g (measured according to BET method) and average primary particle size of 0.03 µm and 1 weight part of N-methylpyrrolidone solution of polyvinylidene fluoride (binder) were mixed to form a paste. One of the platinum surface of the inner counter-electrode layer was coated with the paste, and heated at 150°C in the dry air for 10 minutes to cover the platinum surface with a carbonaceous layer containing active carbon (thickness: about 150 µm, coated amount of carbon: 2 mg/cm²).

### (Formation of conductive layer on substrate)

One surface of a polyethylene naphthalate (PEN) film was coated with an indium-zinc oxide (IZO) conductive layer to prepare a transparent conductive IZO-PEN film (thickness: 200 µm, surface resistance: 10 Ω per square).

### (Formation of semiconductor layer)

30 g of crystallized titanium dioxide nanometer particles (Showa Denko K.K., mixture of rutile and anatase structures, average particle size: 20 nm) was dispersed in 100 ml of a mixed solvent of 95 weight parts of tert-butanol (purity: 99.5% or more) and 5 weight parts of acetonitrile (purity: 99.55 or more), and stirred to give dispersion.

An acidic aqueous titanium oxide sol (concentration: 8 wt.%) was prepared by dispersing titanium dioxide particles (particle size: 5 nm) in a mixed solvent of 50 weight parts of water and 50 weight parts of ethanol.

10 wt.% (based on the dispersion) of the above-prepared aqueous sol and the dispersion were uniformly mixed in a mixing conditioner revolving on both inside and outside axes to prepare a viscous titania paste. The IZO conductive layer was coated with the titania paste by a doctor-blade method, and dried at 150°C for 10 minutes to prepare a semiconductor layer of n-type comprising a porous titanium dioxide particle layer on the IZO-PEN film. The IZO-PEN film coated with the porous titanium dioxide was immersed in a dye solution of a ruthenium (Ru) tris(bipyridyl) complex derivative (Solaronix, Ru535bisTBA, also called N719) in a mixture of acetonitrile with tert-butanol at 40°C for 1 hour. The titanium dioxide membrane was thus coated and sensitized with the ruthenium dye. The membrane sensitized with the dye has a thickness of 10 µm, a surface roughness coefficient of 1,500 and a porosity of 70%.

### (Preparation of photochargeable capacitor)

An organic electrolytic solution (iodine: 0.05 M, lithium iodide: 0.1 M, 4-tert-butylpyridine: 0.5 M) was prepared for a charge transfer layer. The iodine and the lithium iodide were used as redox agents. The solvent was propyl carbonate.

A non-aqueous (dry) electrolytic solution containing no redox agent was prepared for a layered capacitor unit. The solution contains 20 wt.% of tetraethylammonium tetrafluoroborate as a supporting salt. The solvent of the capacitor was dipropyl carbonate.

Two porous propylene films (thickness: 20 µm, porosity: 70%) were inserted between the outer storage layer and the inner storage material layer and between the inner counter-electrode layer and the semiconductor layer to prepare the layered structure shown in Fig. 1. The sides of the layered structure were sealed with a heat-adhesive sealant.

Small pores for electrolyte injection were formed Small pore were formed on the outer counter electrode and the photovoltaic electrode. The non-aqueous electrolytic solution containing no redox agent was inserted through the pore into the space (thickness: 20 µm) between the outer storage layer and the inner storage material layer. The organic electrolytic solution was inserted through the pore into the space (thickness: 20 µm) between the inner counter-electrode layer and the semiconductor layer. The pores were sealed to prepare a photochargeable capacitor in the form of a film (thickness: about 840 µm, effective light receiving area for light irradiation: 1 cm²).

The prepared photochargeable layered (electric double layer) capacitor comprised outer and inner storage material layers made of a carbonaceous material (active carbon).

### EXAMPLE 2

### (Preparation of outer counter-electrode layer)

A metallic titanium sheet (thickness: 50 µm) was used as an outer counter-electrode layer.

### (Formation of outer storage material layer)

The outer storage material layer was formed on the outer counter-electrode layer in the same manner as in the Example 1.

### (Preparation of inner counter-electrode layer)

Surfaces of a titanium sheet (thickness: 50 µm) were covered with platinum membrane (thickness: 20 nm) to prepare an inner counter-electrode layer.

### (Formation of inner storage material layer)

1 weight part of ruthenium dioxide (average particle size: 18 µm), 2 weight parts of tin dioxide (average particle size: 60 nm) and 2 weight parts of nickel oxide (average particle size: 8 µm) were mixed to prepare active material powder. The active material powder was ground in an agate mortar. 10 weight parts of the powder was mixed with 1 weight part of an N-methylpyrrolidone solution of polyvinylidene fluoride (binder) to prepare a paste. One surface of the inner counter-electrode layer (titanium sheet) was coated with the paste, heated at 150°C in the air for 10 minutes, and mechanically pressed to cover the surface with the metal oxide (thickness: about 30 µm, coated amount of metal oxide: 4.5 mg/cm²).

### (Formation of conductive layer on substrate)

One surface of a polyethylene naphthalate (PEN) film was coated with an indium-zinc oxide (IZO) conductive layer to prepare a transparent conductive IZO-PEN film (thickness: 200 µm, surface resistance: 10 Ω per square).

### (Formation of semiconductor layer)

A semiconductor layer was formed on the conductive layer in the same manner as in Example 1.

### (Preparation of photochargeable capacitor)

An organic electrolytic solution (iodine; 0.05 M, lithium iodide: 0.1 M, 4-tert-butylpyridine: 0.5 M) was prepared for a charge transfer layer. The iodine and the lithium iodide function as redox agents. The solvent was propyl carbonate.

A 1 M aqueous solution of perchloric acid (or a 0.1 M aqueous solution of sulfuric acid) was used as an ionic electrolytic solution containing no redox agent for a layered capacitor unit.

A porous cellulose film (thickness: 50 µm, porosity: 70%) were inserted between the outer storage layer and the inner storage material layer as a separator to prepare the layered structure shown in Fig. 1. The sides of the layered structure were sealed with a heat-adhesive sealant.

Small pores for electrolyte injection were formed on the outer counter electrode and the photovoltaic electrode. The ionic electrolytic solution containing no redox agent was inserted through the pore into the space (thickness: 50 µm) between the outer storage layer and the inner storage material layer. The organic electrolytic solution was inserted through the pore into the space (thickness: 50 µm) between the inner counter-electrode layer and the semiconductor layer. The pores were sealed to prepare a photochargeable capacitor in the form of a film (thickness: about 600 µm, effective light receiving area for light irradiation: 1 cm²).

The prepared photochargeable layered (electrochemical) capacitor comprised an outer storage material layer made of a carbonaceous material (active carbon) and an inner storage material layer made of an inorganic active material (electrodically active material).

### EXAMPLE 3

### (Preparation of outer counter-electrode layer)

A metallic titanium sheet (thickness: 50 µm) was used as an outer counter-electrode layer.

### (Formation of outer storage material layer)

A conductive polypyrrole was prepared according to an electrolytic polymerization method. 1 weight part of the conductive polypyrrole was mixed with 1 weight part of the active carbon prepared in Example 1, 10 weight parts of the mixture was dispersed in 1 weight part of N-methylpyrrolidone solution of polyvinylidene fluoride (binder) to form a paste. One surface of the inner counter-electrode layer (titanium sheet) was coated with the paste, heated at 100°C in the air for 10 minutes to cover the surface with a storage layer comprising a carbonaceous material and an electrodically active material (thickness: about 200 µm, coated amount of polypyrrole: 1.0 mg/cm²).

### (Preparation of inner counter-electrode layer)

Surfaces of a titanium sheet (thickness: 50 µm) were covered with platinum membrane (thickness: 20 nm) to prepare an inner counter-electrode layer.

### (Formation of inner storage material layer)

1 weight part of the active material powder (mixture of ruthenium dioxide, tin dioxide and nickel oxide) prepared in Example 2 was mixed with 1 weight part of the active carbon prepared in Example 1. The mixed powder was ground in an agate mortar. 10 weight parts of the powder were mixed with 1 weight part of an N-methylpyrrolidone solution of polyvinylidene fluoride (binder) to prepare a paste. One surface of the inner counter-electrode layer (titanium sheet) was coated with the paste, heated at 150°C in the air for 10 minutes, and mechanically pressed to cover the surface with a storage layer comprising a carbonaceous material and an electrodically active material (thickness: about 100 µm, coated amount of metal oxide: 3.0 mg/cm²).

### (Formation of conductive layer on substrate)

One surface of a polyethylene naphthalate (PEN) film was coated with an indium-zinc oxide (IZO) conductive layer to prepare a transparent conductive IZO-PEN film (thickness: 200 µm, surface resistance: 10 Ω per square).

### (Formation of semiconductor layer)

A tight titanium dioxide layer (thickness: about 1 µm) was formed as a buffer layer according to a vacuum sputtering method on the conductive layer prepared in Example 1.

The buffer layer was coated with the titania paste with a doctor blade in the same manner as in Example 1, and dried at 150°C for 10 minutes to prepare a semiconductor layer of n-type comprising a porous titanium dioxide particle layer on the buffer layer. The porous titanium dioxide membrane was coated and sensitized with the ruthenium dye in the same manner as in Example 1 to form a semiconductor layer (thickness: 10 µm).

### (Formation of charge transfer layer)

An acetonitrile solution of potassium iodide was dropwise added to the surface of the sensitized porous titanium dioxide membrane. The solvent was evaporated to form a solid thin membrane of potassium iodide. The surface of the porous membrane was coated with a dichloromethane solution (1 g per liter) of polyvinyl carbazole (positive-hole transporting material) by a spin coater, and dried to form a positive-hole transporting layer (thickness: about 1 µm).

Graphite was dispersed in a dimethylformamide solution of polyvinylidene fluoride. The positive-hole transporting layer was coated with the dispersion, and dried at 80°C for 20 minutes to form a graphite layer (thickness: about 300 µm).

### (Preparation of photochargeable capacitor)

A 1 M acetonitrile solution of perchloric acid was used as an ionic electrolytic solution containing no redox agent for a layered capacitor unit.

The inner counter-electrode layer was placed on the graphite layer. A porous propylene film (thickness: 20 µm, porosity: 70%) was inserted between the outer storage layer and the inner storage material layer to prepare the layered structure shown in Fig. 1. The sides of the layered structure were sealed with a heat-adhesive sealant.

Small pore for electrolyte injection were formed on the outer counter electrode and the photovoltaic electrode. The ionic electrolytic solution containing no redox agent was inserted through the pore into the space (thickness: 20 µm) between the outer storage layer and the inner storage material layer. The pore was sealed to prepare a photochargeable capacitor in the form of a film (effective light receiving area for light irradiation: 1 cm²).

The prepared photochargeable layered (electrochemical) capacitor comprised a charge transfer layer made of a positive-hole transporting material, and an outer and inner storage material layers made of hybrid materials (a carbonaceous material and an electrodically active material).

### (Evaluation of charging characteristics)

The photochargeable layered capacitors prepared in Examples 1 to 3 were subjected to the following charging and discharging experiments to evaluate charging characteristics. The conductive layer of the photovoltaic electrode unit and the outer counter-electrode layer were connected with an external circuit to reduce the voltage between the electrodes to zero. The capacitor was irradiated with white light from the surface of the photovoltaic electrode unit using a 500 W solar simulator equipped with an Air Mass 1.5 (AM1.5) filter as a light source. The intensity of light was 100 mW/cm².

While exposing the capacitor to light, electrons were injected into the conductive layer of the photovoltaic electrode unit, and caused an anodic current by the electron flow from the conductive layer to the outer counter-electrode layer through the shunt external circuit. Under the condition of open circuit a negative photovoltage (-0.4 V or less) was caused by light irradiation to the photovoltaic electrode unit. After 10 seconds of light irradiation, a photocurrent was measured as the charging current. The light irradiation was continued under the condition of the shunt circuit to show that the photo voltaic current was gradually reduced with the time of the light irradiation. The open circuit voltage was also measured with light irradiation to confirm that the voltage of the outer counter-electrode was more negative than the voltage of the photovoltaic electrode unit, and that the difference increases with the time of the light irradiation. Therefore, it was confirmed that a negative charge was stored in the outer storage layer while irradiating the capacitor with light to charge it. After 1 hour of light irradiation, the circuit was opened to measure to the charged voltage.

The capacitor was placed in the darkness to measure the discharge characteristics. The external circuit was closed (or detached from the capacitor), and discharge was conducted at a constant current density of 0.05 mA/cm² (under constant current discharging condition) using a charge and discharge controller (Multi Potentiostat PS-08, Tohogiken, Inc.). The voltage decreases with the time of the discharge. The termination voltage of the discharge was set at 0 V. After the voltage reached 0 V with the constant current discharge, the discharged current was reduced to keep the 0 V (under constant-voltage potentiostatic discharging condition). The discharged electric amount per the electrode area unit (mC/cm²) was measured as the dischargeable capacity.

The charging and discharging characteristic of the capacitors are set forth in Table 1. The photochargeable layered capacitors constructed according to the present invention showed high charging voltage and large dischargeable capacity. After repeating photovoltaic charge and discharge 10 times, the capacitors showed high charging voltage to confirm the stable functions.

**TABLE 1**

| | Outer/inner storage materials | Charging current density | Charged voltage | Discharge capacity |
|---|---|---|---|---|
| Example 1 | C/C | 12 mA/cm² | 0.80 V | 450 mC/cm² |
| Example 2 | C/A | 12 mA/cm² | 0.80 V | 400 mC/cm² |
| Example 3 | (C+A) / (C+A) | 10 mA/cm² | 0.65 V | 350 mC/cm² |

| | | | | |
|---|---|---|---|---|
| (Remark) C: Carbonaceous material A: Electrode active materia | | | | |

## Claims

1. A photochargeable layered capacitor comprising a layered capacitor unit and a photovoltaic electrode unit, said layered capacitor unit comprising an outer counter-electrode layer, an outer storage material layer, a separator impregnated with an ionic electrolyte, an inner storage material layer and an inner counter-electrode layer in order, and said photovoltaic electrode unit comprising a transparent substrate, a transparent conductive layer, a semiconductor layer and a charge transfer layer in order, wherein the charge transfer layer of the photovoltaic electrode unit is in junction with an outer surface of the inner counter-electrode layer of the layered capacitor unit, and wherein the inner counter-electrode layer comprises a single metal sheet.

2. The photochargeable layered capacitor of claim 1, wherein the outer counter-electrode layer of the layered capacitor unit is connected to the transparent conductive layer of the photovoltaic electrode unit with an external circuit.

3. The photochargeable layered capacitor of claim 1, wherein each of the outer and inner counter-electrode layers of the layered capacitor unit has an output terminal.

4. The photochargeable layered capacitor of claim 1, wherein the semiconductor layer of the photovoltaic electrode unit comprises a porous layer having a surface adsorbing a dye.

5. The photochargeable layered capacitor of claim 1, wherein each of the outer and inner storage material layers of the layered capacitor unit comprises a carbonaceous material.

6. The photochargeable layered capacitor of claim 1, wherein each of the outer and inner storage material layers of the layered capacitor unit comprises an electrodically active material having a redox function.

7. The photochargeable layered capacitor of claim 1, wherein one of the outer and inner storage material layers of the layered capacitor unit comprises a carbonaceous material, and the other comprises an electrodically active material having a redox function.

8. The photochargeable layered capacitor of claim 1, wherein the charge transfer layer of the photovoltaic electrode unit comprises an ionic electrolyte containing redox active material.

9. The photochargeable layered capacitor of claim 8, wherein the charge transfer layer of the photovoltaic electrode unit comprises a separator impregnated with the ionic electrolyte and the redox active material.

10. The photochargeable layered capacitor of claim 1, wherein the single metal sheet of the inner counter-electrode layer comprises titanium or an alloy thereof.

11. The photochargeable layered capacitor of claim 10, wherein the single metal sheet comprising titanium or an alloy thereof has a surface covered with platinum membrane, and the charge transfer layer of the photovoltaic electrode unit is provided on the surface.
